# EUROPEAN PATENT APPLICATION

(11) **EP 4 203 035 A1**
(43) Date of publication of application: **28.06.2023**
(21) Application number: 22205251.6
(22) Date of filing: 03.11.2022
(51) Int. Cl.: H01L 27/088, H01L 29/775, H01L 29/786, H01L 21/8234, H01L 29/06

(54) **SEMICONDUCTOR STRUCTURE FOR NANORIBBON ARCHITECTURES**

(30) Priority: 21.12.2021 US 202117557932
(71) Applicant: Intel Corporation, Santa Clara, CA 95054 (US)
(72) Inventor: GULER, Leonard P., Hillsboro, 97124 (US); GHANI, Tahir, Portland, 97229 (US); WALLACE, Charles H., Portland, 97212 (US)
(74) Representative: Goddar, Heinz J.

(57) **Abstract**

Embodiments disclosed herein include semiconductor devices and methods of forming such devices. In an embodiment, a semiconductor device comprises a fin with a first end and a second end. In an embodiment, a first dielectric covers the first end of the fin, and a second dielectric covers the second end of the fin. In an embodiment, a gate structure is over the first end of the fin, where the gate structure is on a top surface of the fin and a top surface of the first dielectric.

## Description

### TECHNICAL FIELD

Embodiments of the disclosure are in the field of semiconductor structures and processing and, in particular, to nanoribbon structures with a dielectric fill at ends of the fin structure.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 10 nanometer node or sub-10 nanometer node range. Consequently, fabrication of the functional components needed for future technology nodes may require the introduction of new methodologies or the integration of new technologies in current fabrication processes or in place of current fabrication processes.

In the manufacture of integrated circuit devices, multi-gate transistors, such as tri-gate transistors and gate-all-around (GAA) transistors, have become more prevalent as device dimensions continue to scale down. Tri-gate transistors and GAA transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

### BRIEF DESCRIPTION OF THE DRAWINGS

Figure 1A is a plan view illustration of fins on a substrate, in accordance with an embodiment.
Figure 1B is a plan view illustration of the fins with a spacer layer formed over the fins, in accordance with an embodiment.
Figure 1C is a plan view illustration of the fins after a dielectric layer is disposed around the spacer layer, in accordance with an embodiment.
Figure 1D is a plan view illustration of the fins after spacers are removed and a gate structure is disposed over the fins, in accordance with an embodiment.
Figure 2 is a cross-sectional illustration of the structure in Figure 1D that shows portions of the gate structure extending down a side of the fin, in accordance with an embodiment.
Figure 3A is a plan view illustration of fins on a substrate, in accordance with an embodiment.
Figure 3B is a plan view illustration of the fins after a spacer layer is formed over the fins, in accordance with an embodiment.
Figure 3C is a plan view illustration of the fins after a plurality of cuts are made to split one or more of the fins, in accordance with an embodiment.
Figure 3D is a plan view illustration of the fins after a dielectric layer is disposed around the fins and the spacers, in accordance with an embodiment.
Figure 3E is a plan view illustration of the fins after the spacers are removed and a gate structure is disposed over the fins, in accordance with an embodiment.
Figure 4A is a cross-sectional illustration of the fins in Figure 3E along line A-A, in accordance with an embodiment.
Figure 4B is a cross-sectional illustration of one of the fins in Figure 3E along line B-B, in accordance with an embodiment.
Figure 5A is a perspective view illustration of fins on a substrate, in accordance with an embodiment.
Figure 5B is a perspective view illustration of the fins after a spacer is disposed over the fins, in accordance with an embodiment.
Figure 5C is a perspective view illustration of the fins after the fins and spacer are recessed at certain locations, in accordance with an embodiment.
Figure 5D is a perspective view illustration of the fins after a dielectric layer is disposed around the spacers, in accordance with an embodiment.
Figure 5E is a perspective view illustration of the fins after the spacers are removed and a gate structure is formed over the fins, in accordance with an embodiment.
Figure 6 illustrates a computing device in accordance with one implementation of an embodiment of the disclosure.
Figure 7 is an interposer implementing one or more embodiments of the disclosure.

### DESCRIPTION OF THE EMBODIMENTS

Embodiments described herein comprise nanoribbon structures with a dielectric fill at ends of the fin structure. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

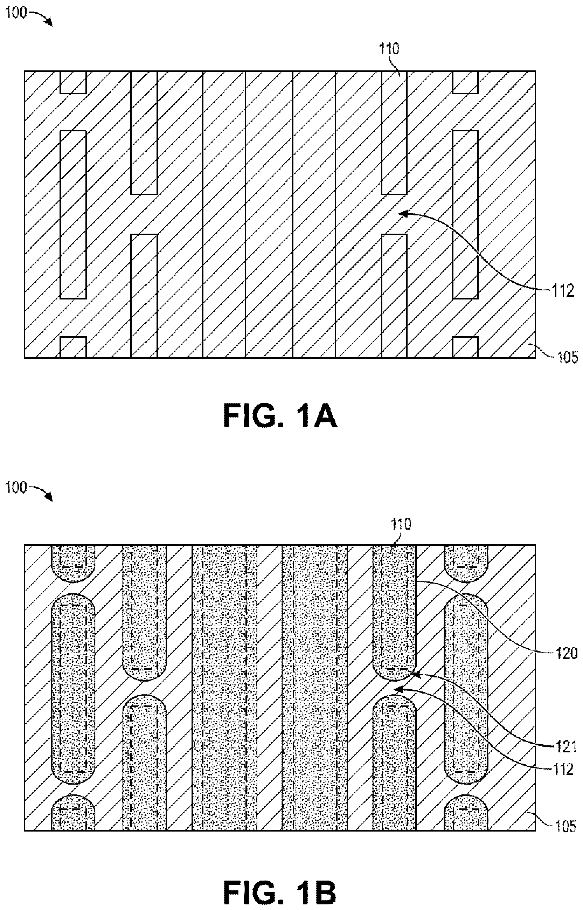

To provide context, Figures 1A-1D illustrate some processing operations used in the manufacture of nanoribbon or nanowire transistor structures. As shown in the plan view illustration of Figure 1A, a semiconductor device 100 includes a plurality of fins 110 that are provided over a substrate. The fins 110 may be fabricated from layers of alternating materials. For example, a channel material is alternated with a sacrificial layer. The layers of alternating materials are then patterned into fins, as depicted in Figure 1A. The fins 110 have a length (the up to down direction in Figure 1A) that is greater than their width (the left to right direction in Figure 1A). In some instances, the plurality of fins 110 are already patterned. That is, cuts 112 through the fins 110 are present at this point in the process flow. An isolation layer 105 may be provided over the substrate and over the surfaces of the fins 110. The isolation layer 105 may be a shallow trench isolation (STI) layer or the like. For example, the isolation layer 105 may comprise silicon and oxygen (e.g., SiO₂), or the like.

Referring now to Figure 1B, a plan view illustration of the fins 110 after a spacer layer 120 is disposed over the sidewall and top surface of the fins 110 is shown. The spacer layer 120 may be an insulating material. For example, the spacer layer 120 may be a material that is etch selective to the isolation layer 105. In some instances, the deposition process used to form the spacer layer 120 is a conformal deposition process. As such, the surfaces of the fins facing the cuts 112 will also grow the spacer layer 120. As depicted in Figure 1B, the end surfaces 121 of the spacer layer 120 grow into the cuts 112 between fins 110. As will be described in greater detail below, this additional growth of the spacer layer 120 results in potential defects in the semiconductor device 100. For example, the subsequently deposited gate structure may be able to extend down the surfaces of the fin 110 facing the cuts 112.

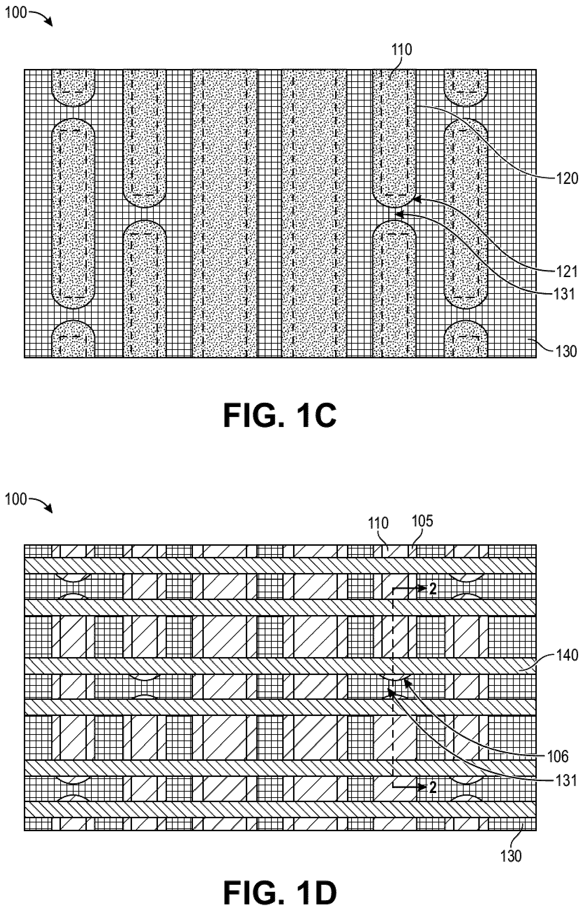

Referring now to Figure 1C, a plan view illustration of the semiconductor device 100 after a dielectric layer 130 is provided around the spacer layer 120 is shown. The dielectric layer 130 may be any suitable dielectric material that is etch selective to the spacer layer 120. For example, the dielectric layer 130 may be an oxide, a nitride, a carbide, or the like. As shown, the dielectric layer 130 includes portions 131 of dielectric material that fill the cuts 112 between the fins 110. Due to the structure of the surface 121, the portions 131 may have curved surfaces. Additionally, it is to be appreciated that the spacer layer 120 spaces the dielectric layer 130 away from the fins 110. That is, no portion of the fins 110 directly contact the dielectric layer 130.

Referring now to Figure 1D, a plan view illustration of the semiconductor device 100 after the spacer layer 120 is removed and a gate structure 140 is disposed across the fins 110 is shown. As shown, the removal of the spacer layer 120 results in the exposure of the isolation layer 105 around a perimeter of the fins 110. Due to the spacer layer 120 extending into the cutouts 112 a portion 106 of the isolation layer 105 extends past an end of the fins 110. Accordingly, there is a gap between the ends of the fins 110 and the portion 131 of the dielectric layer 130 between the fins 110. This allows for the gate structure to extend down a face of the fins 110.

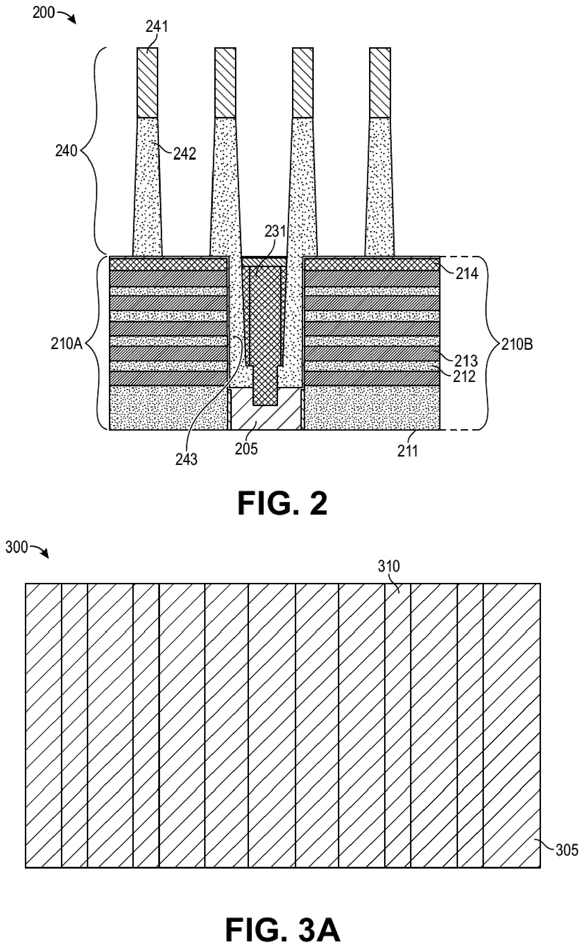

For example, Figure 2 is a cross-sectional illustration of a semiconductor device 200, as seen along line 2-2 in Figure 1D. As shown, a pair of fins 210_{A} and 210_{B} are provided. The pair of fins 210_{A} and 210_{B} may each comprise a base substrate 211 and a plurality of alternating layers 212 and 213. Layers 212 may be channel layers. That is, semiconducting channels will ultimately be made with layers 212. Layers 213 may be sacrificial layers. That is, layers 213 will ultimately be removed from the structure. The isolation layer 205 may separate the two ends of the fins 210_{A} and 210_{B} below the layers 212 and 213. At the level of the layers 212 and 213, the fins 210_{A} and 210_{B} may be separated by a portion 231 of the dielectric layer that surrounds the fins 210_{A} and 210_{B}. However, since the portion 231 does not directly contact the end surfaces of the fins 210_{A} and 210_{B}, portions 243 of the gate structure 240 may extend down the end surfaces of the fins 210_{A} and 210_{B}. The gate structure 240 may comprise a mask layer 241 and an underlying polysilicon layer 242. The portions 243 are part of the polysilicon layer 242.

Accordingly, embodiments disclosed herein include a process flow that enables the dielectric layer to be in direct contact with ends of the fins. As such, there is no gap into which the polysilicon of the gate structure can be deposited. Instead, the gate structure is provided over an interface between the fin and the dielectric layer. In order to provide such a structure, the fins are not cut until after the spacer layer is deposited over the fins. After depositing the spacer layer, the cut in the fin is made through both the spacer and the fin. This exposes the end surface of the fin so that the dielectric layer can directly contact the end of the fin. Additionally, the remainder of the spacer remains in order to space the dielectric away from the edges of the fin that connect the ends together. An example of such a process flow is provided in Figures 3A-3E.

Referring now to Figure 3A, a cross-sectional illustration of a semiconductor device 300 is shown, in accordance with an embodiment. In an embodiment, the semiconductor device 300 may be fabricated over a substrate (which is below the isolation layer 305). The underlying substrate may be a semiconductor substrate such as a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials.

In an embodiment, the isolation layer 305 may be provided between fins 310. The fins 310 in Figure 3A are also shown as being covered by the material of the isolation layer 305. However, it is to be appreciated that the fins 310 extend up from the isolation layer 305 (i.e., out of the page). The isolation layer 305 may include any suitable electrically insulating material, such as, but not limited to, a material comprising silicon and oxygen (e.g., SiO₂). The isolation layer 305 may be considered a shallow trench isolation (STI) feature in some embodiments.

In an embodiment, the fins 310 may be semiconductor fins suitable for forming nanoribbon or nanowire devices. For example, the fins 310 may comprise alternating first layers and second layers. The first layers may be a semiconductor material used to form semiconductor channels, and the second layers may be a material that is etch selective to the first layers. Fins 310 may be formed by known methods, such as forming alternating first layers and the second layers over the underlying substrate, and then etching the layers to form a fin-type structure, (e.g., with a mask and plasma etch process).

In an embodiment, sacrificial material of the second layers may be any material that can be selectively etched with respect to the material of the first layers. Materials for the first layers and the second layers may include material such as, but not limited to, silicon, germanium, SiGe, GaAs, InSb, GaP, GaSb, InAlAs, InGaAs, GaSbP, GaAsSb, and InP. In a specific embodiment, the first layers are silicon and second layers are SiGe. In another specific embodiment, the first layers are germanium, and second layers are SiGe.

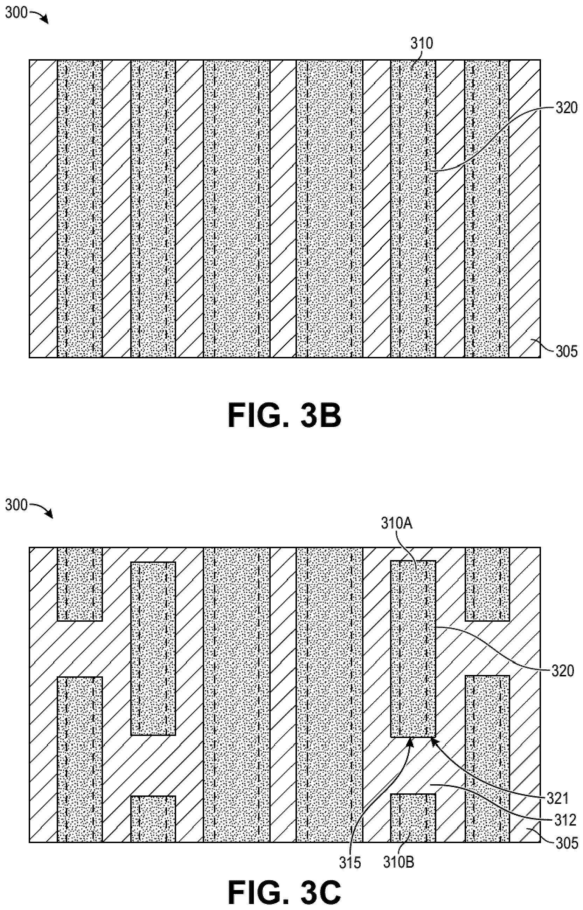

Referring now to Figure 3B, a plan view illustration of the semiconductor structure 300 is shown, in accordance with an embodiment. As shown in Figure 3B, a spacer 320 is disposed over and around the fins 310. The fins 310 are illustrated with dashed lines in Figure 3B in order to illustrate their presence under the spacers 320. In an embodiment, the spacers 320 may comprise a material that is etch selective to the isolation layer 305. In an embodiment, the spacers 320 are formed with a conformal deposition process.

Referring now to Figure 3C, a plan view illustration of the semiconductor structure 300 is shown, in accordance with an embodiment. As shown in Figure 3C, one or more of the fins 310 are cut to provide cutouts 312 between fins 310. In an embodiment, some of the fins 310 may be cut more than once, in order to provide multiple cutouts 312 along the length of a fin 310. As labeled in Figure 3C, the cutouts 312 segment the fins into a first fin 310_{A} and a second fin 310_{B}. In an embodiment, the patterning process used to pattern the fins 310 also results in the spacer 320 being patterned with matching cutouts. Accordingly, the end surfaces of the fins 310 are substantially coplanar with the end surfaces of the spacer 320. For example, end surface 315 of the first fin 310_{A} is substantially coplanar with an end surface 321 of the spacer 320.

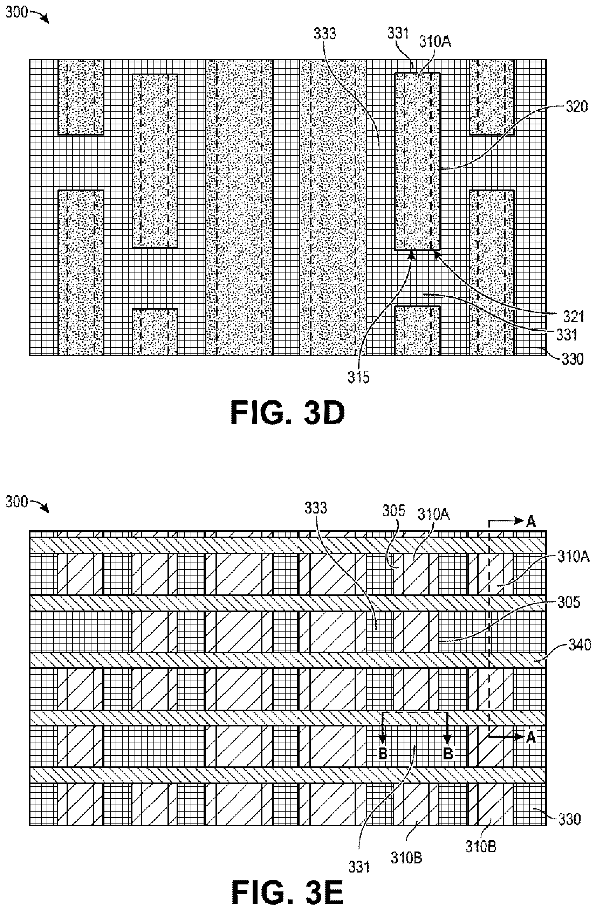

Referring now to Figure 3D, a plan view illustration of the semiconductor structure 300 is shown, in accordance with an embodiment. As shown in Figure 3C, a dielectric layer 330 is disposed around the spacers 320. In an embodiment, the dielectric layer 330 comprises a material that is etch selective to the spacers 320. For example, the dielectric layer may comprise a nitride, an oxide, a carbide, or the like. In an embodiment, the dielectric layer 330 directly contacts the end surfaces 315 of the cut fins 310. Likewise, the dielectric layer 330 contacts the end surfaces 321 of the cut spacers 320. For ease of reference, the portion of the dielectric layer 330 between the cuts may be referred to as region 331. The regions 331 may be coupled together by regions 333 of the dielectric layer 330. The regions 333 may extend along a length of the fins 310. However, in contrast to regions 331, the regions 333 may not directly contact portions of the fins 310.

Referring now to Figure 3E, a plan view illustration of the semiconductor structure 300 is shown, in accordance with an embodiment. As shown in Figure 3E, the spacers 320 are removed and gate structures 340 are formed. In an embodiment, the spacers 320 may be removed with an etching process that is selective to the spacer material over the dielectric layer 330. As such, the spacers 320 are removed without substantially altering the structure of the dielectric layer 330. Removal of the spacers 320 results in the exposure of the isolation layer 305 along the length of the fins 310. That is, the fins 310 remain spaced away from the regions 333 of the dielectric layer 330. As shown, some of the gate structures 340 may pass over the ends of the fins 310. However, in contrast to the example shown in Figures 1A-1D and Figure 2, the gate structure 340 does not extend down and contact the end surface of the fins 310.

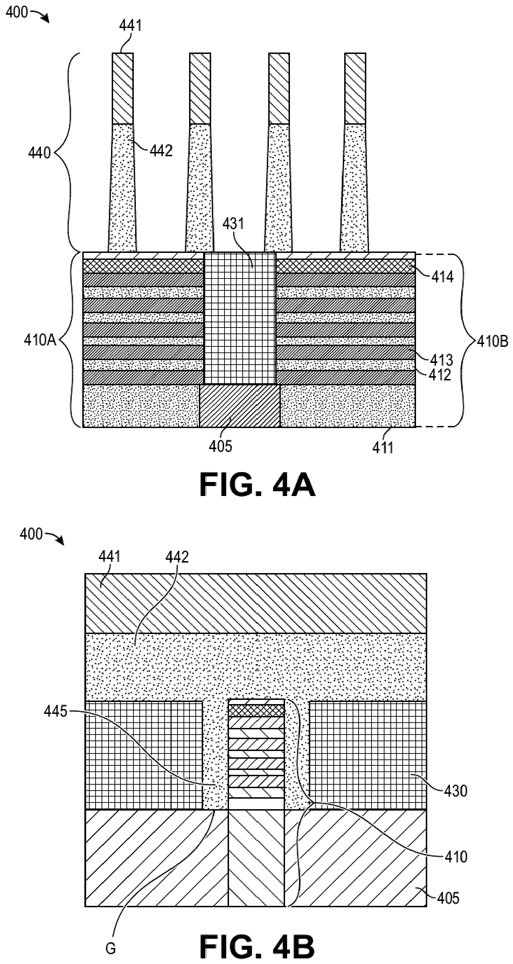

The interface between the ends of the fins 310_{A} and 310_{B} and the portion 331 of the dielectric layer 330 between the fins 310_{A} and 310_{B} along line A-A in Figure 3E is shown in a cross-sectional view in Figure 4A. Referring now to Figure 4A, a cross-sectional illustration of the semiconductor structure 400 is shown, in accordance with an embodiment. The first fin 410_{A} and the second fin 410_{B} include first layers 412 and second layers 413 over a substrate 411. The first layers 412 and the second layers 413 may be substantially similar to first layers and second layers described in greater detail above. For example, the first layers 412 may be channel material, and the second layers 413 may be sacrificial layers. In an embodiment, a dielectric cap 414 may be provided over the top of the fins 410_{A} and 410_{B}.

In an embodiment, the fin 410_{A} may be separated from the fin 410_{B} by the insolation layer 405 and the portion 431 of the dielectric layer 430. As shown, the portion 431 of the dielectric layer 430 may be directly in contact with the ends of the fins 410_{A} and 410_{B}. Additionally, the top surface of the portion 431 of the dielectric layer 430 and the top surface of the fins 410_{A} and 410_{B} may be substantially coplanar with each other. Though, it is to be appreciated that the portion 431 of the dielectric layer 430 and the fins 410_{A} and 410_{B} may have top surfaces that are not substantially coplanar in some embodiments. As used herein, substantially coplanar may refer to two surfaces that are within approximately 5nm of being coplanar with each other. It is to be appreciated that fabrication tolerances may result in features that appear coplanar in the Figures being non-coplanar in practice.

In an embodiment, gate structures 440 may be provided over top surfaces of the fins 410 and the portion 431 of the dielectric layer 430. The gate structures 440 may comprise polysilicon 442 and mask layers 441 over the polysilicon 442. In contrast to the embodiment shown above in Figure 2, the polysilicon 442 does not contact the sidewall of the fins 410_{A} and 410_{B}. Instead, for some of the gate structures, bottom surfaces of the polysilicon 442 may contact both the top surface of the fins 410 and the top surface of the portion 431 of the dielectric layer 430.

In the illustrated embodiment, a stage of manufacture is shown. However, it is to be appreciated that additional processing may continue in order to complete the fabrication of transistor devices. For example, the portions of the fins 410 outside of the gate structures 440 may be etched and replaced with source and drain regions. After formation of the source and drain regions, the gate structure may be replaced with a metal gate structure with processes typically referred to as replacement metal gate processes. In such an embodiment, a dielectric layer surrounds the gate structures 440, and the gate structures 440 are removed. At this time the sacrificial second layers 413 may be removed, and replaced with a gate stack. The gate stack may include a gate dielectric, and a metal over the gate dielectric. The metal may comprise a workfunction metal directly over the gate dielectric, and a fill metal.

The gate dielectric may be, for example, any suitable oxide such as silicon dioxide or high-k gate dielectric materials. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

When the workfunction metal will serve as an N-type workfunction metal, the workfunction metal preferably has a workfunction that is between about 3.9 eV and about 4.2 eV. N-type materials that may be used to form the workfunction metal include, but are not limited to, hafnium, zirconium, titanium, tantalum, aluminum, and metal carbides that include these elements, i.e., titanium carbide, zirconium carbide, tantalum carbide, hafnium carbide and aluminum carbide. When the workfunction metal will serve as a P-type workfunction metal, the workfunction metal preferable has a workfunction that is between about 4.9 eV and about 5.2 eV. P-type materials that may be used to form the workfunction metal include, but are not limited to, ruthenium, palladium, platinum, cobalt, nickel, and conductive metal oxides, e.g., ruthenium oxide.

While the structure of the fins 410_{A} and 410_{B} and the gate structure 440 may be changed during additional fabrication, it is to be appreciated that the portion 431 of the dielectric layer 430 persists in the semiconductor structure 400. For example, since the portion 431 is adjacent to a part of a fin below a gate structure 440, the contact between the portion 431 and the second layers 413 may be replaced with contact between the portion 431 and the gate dielectric or another portion of the replacement metal gate stack. The first layers 412 may remain in contact with the portion 431 in some embodiments.

Referring now to Figure 4B, a cross-sectional illustration of the semiconductor structure 400 is shown, in accordance with an embodiment. The cross-section in Figure 4B is similar to the cross-section indicated by line B-B in Figure 3E. As shown, the polysilicon layer 442 is able to wrap around three sides of the fin 410 (i.e., the top surface and sidewall surfaces of the fin 410). This is because there is a gap G between the dielectric layer 430 and the fin 410. The gap G is formed when the spacer layer 445 is removed from the structure. In some instances, the polysilicon may be referred to as having a U-shape around the fin 410. The bottom portion of the polysilicon may interface with the isolation layer 405.

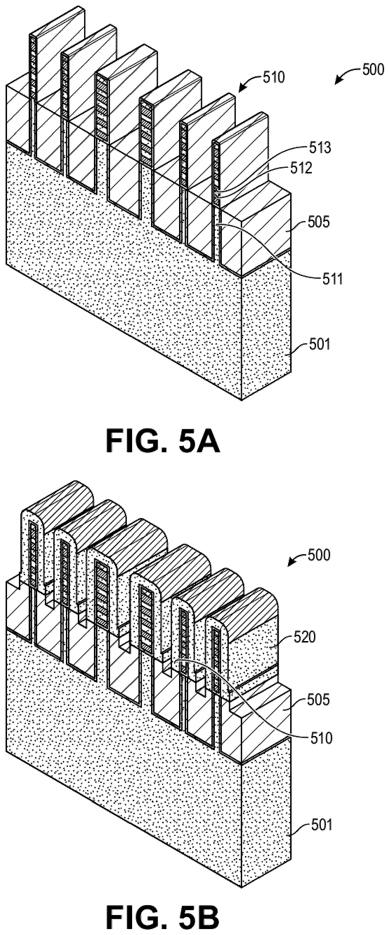

Referring now to Figures 5A-5E, a series of perspective view illustrations depicting a process for forming a semiconductor structure 500 is shown, in accordance with an additional embodiment. Particularly, the embodiments shown in Figures 5A-5E more clearly illustrate the structure of the fin and the surfaces of the fin and the spacer after the cut.

Referring now to Figure 5A, a perspective view illustration of a semiconductor structure 500 is shown, in accordance with an embodiment. In an embodiment, the semiconductor structure 500 may comprise a substrate 501, such as a semiconductor substrate or the like. A fin 510 may extend up from the substrate 501. For example, a sub-fin 511 is provided adjacent to the isolation layer 505, and the alternating first layers 512 and second layers 513 may extend above the isolation layer 505. As shown, a thin layer of the isolation material may also cover the surfaces of the fin 510.

As shown, a plurality of substantially parallel fins 510 may be provided across the surface of the substrate 501. In the illustrated embodiment, widths of the fins 510 may be nonuniform. For example, the middle two fins 510 have a width that is greater than widths of the fins 510 towards the edge of Figure 5A. However, it is to be appreciated that the widths of the fins may be substantially equal in some embodiments. Similarly, a spacing between the fins 510 may be substantially uniform. In other embodiments, the spacing between all fins 510 may not be uniform.

Referring now to Figure 5B, a perspective view illustration of the semiconductor structure 500 after the formation of spacers 520 is shown, in accordance with an embodiment. In an embodiment, the spacers 520 may be conformally deposited over the surfaces of the fins 510. As such, the spacers 520 may wrap around the sidewalls and the top surfaces of the fins 510. As shown, the spacers 520 cover a portion of the isolation layer 505 immediately adjacent to the edges of the fins 510.

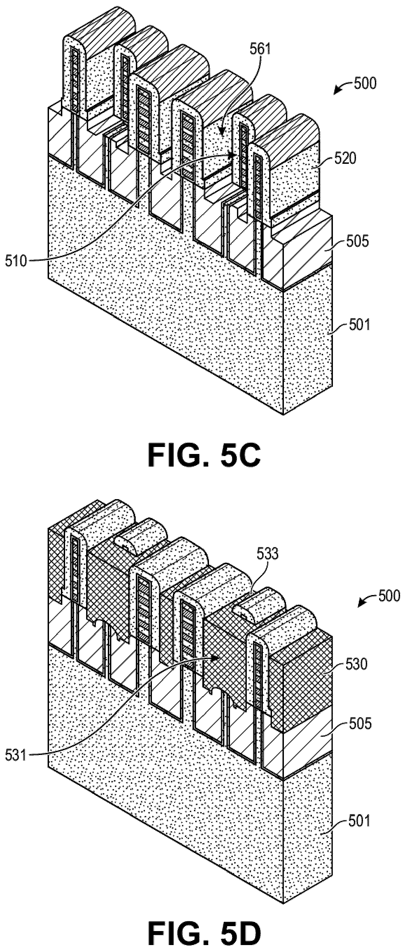

Referring now to Figure 5C, a perspective view illustration of the semiconductor structure 500 after cuts 561 are made through the spacers 520 and the fins 510 is shown, in accordance with an embodiment. As shown, the cuts result in the end face of the fin 510 being substantially coplanar with the end face of the spacer 520. That is, the spacer 520 remains only along the length of the cut fins 510 and not the ends of the fins 510.

Referring now to Figure 5D, a perspective view illustration of the semiconductor structure 500 after the dielectric layer 530 is deposited is shown, in accordance with an embodiment. As shown, portions 531 may be provided against the exposed faces of the fins 510 and spacers 520. Additionally, portions 533 may extend along the length of the fins 510 between edges of the spacers 520.

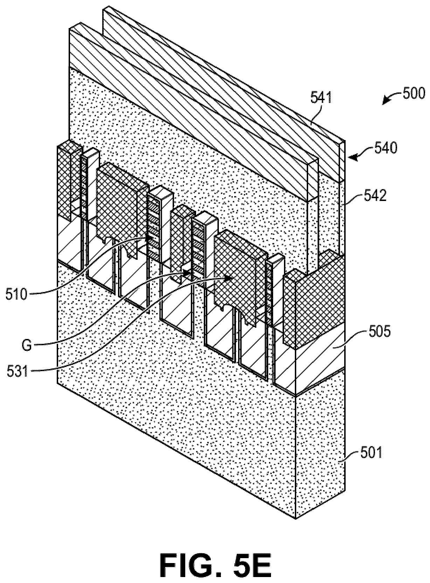

Referring now to Figure 5E, a perspective view illustration of the semiconductor structure 500 after the spacers are removed and a gate structure 540 is formed is shown, in accordance with an embodiment. Removal of the spacers 520 results in a formation of a gap G between the fins 510 and the dielectric layer 530. The gap G allows for the gate structure 540 to wrap around the sidewalls of the fins 510. However, since there is no gap at the end surfaces of the fins 510, the gate structure 540 is prevented from contacting the end surfaces of the fins 510 by the dielectric layer 530.

In an embodiment, the gate structure 540 comprises a polysilicon layer 542 that is under a mask layer 541. It is to be appreciated that additional processing may be implemented in order to form source/drain regions, and form a replacement metal gate. Processing and the resulting structures used to form source/drain regions and replacement metal gate structures are similar to those described in greater detail above, and will not be repeated here.

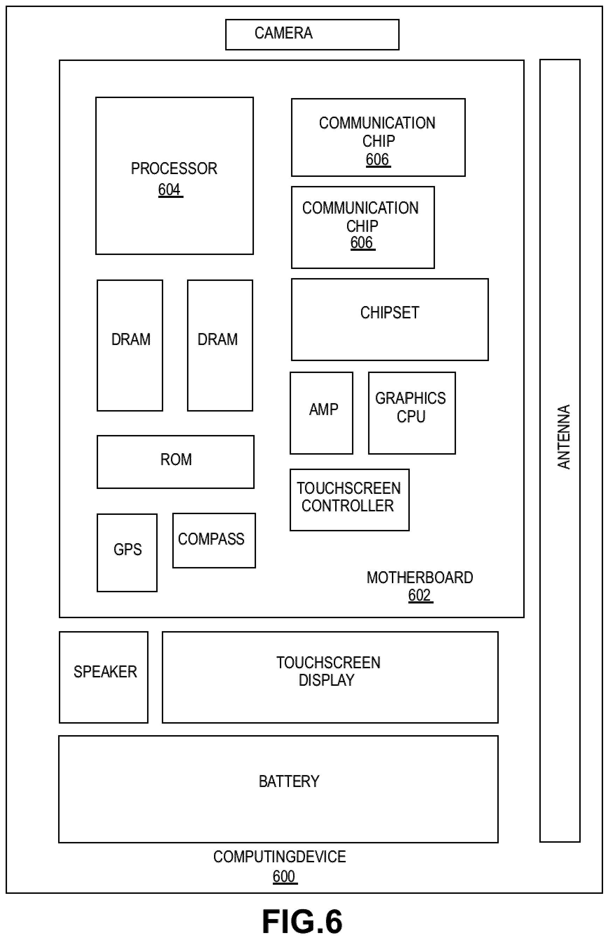

Figure 6 illustrates a computing device 600 in accordance with one implementation of an embodiment of the disclosure. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In an embodiment, the integrated circuit die of the processor may comprise a transistor device with a dielectric layer immediately adjacent to an end of a semiconductor fin, as described herein. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In an embodiment, the integrated circuit die of the communication chip may comprise a transistor device with a dielectric layer immediately adjacent to an end of a semiconductor fin, as described herein.

In further implementations, another component housed within the computing device 600 may comprise a transistor device with a dielectric layer immediately adjacent to an end of a semiconductor fin, as described herein.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

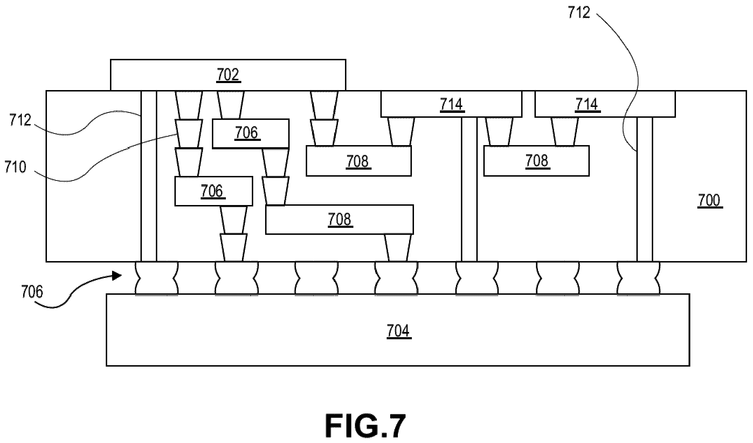

Figure 7 illustrates an interposer 700 that includes one or more embodiments of the disclosure. The interposer 700 is an intervening substrate used to bridge a first substrate 702 to a second substrate 704. The first substrate 702 may be, for instance, an integrated circuit die. The second substrate 704 may be, for instance, a memory module, a computer motherboard, or another integrated circuit die. In an embodiment, one of both of the first substrate 702 and the second substrate 704 may comprise a transistor device with a dielectric layer immediately adjacent to an end of a semiconductor fin, in accordance with embodiments described herein. Generally, the purpose of an interposer 700 is to spread a connection to a wider pitch or to reroute a connection to a different connection. For example, an interposer 700 may couple an integrated circuit die to a ball grid array (BGA) 706 that can subsequently be coupled to the second substrate 704. In some embodiments, the first and second substrates 702/704 are attached to opposing sides of the interposer 700. In other embodiments, the first and second substrates 702/704 are attached to the same side of the interposer 700. And in further embodiments, three or more substrates are interconnected by way of the interposer 700.

The interposer 700 may be formed of an epoxy resin, a fiberglass-reinforced epoxy resin, a ceramic material, or a polymer material such as polyimide. In further implementations, the interposer 700 may be formed of alternate rigid or flexible materials that may include the same materials described above for use in a semiconductor substrate, such as silicon, germanium, and other group III-V and group IV materials.

The interposer 700 may include metal interconnects 708 and vias 710, including but not limited to through-silicon vias (TSVs) 712. The interposer 700 may further include embedded devices 714, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 700. In accordance with embodiments of the disclosure, apparatuses or processes disclosed herein may be used in the fabrication of interposer 700.

Thus, embodiments of the present disclosure may comprise a transistor device with a dielectric layer immediately adjacent to an end of a semiconductor fin.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: a semiconductor device, comprising: a fin with a first end and a second end; a first dielectric that covers the first end of the fin; a second dielectric that covers the second end of the fin; a gate structure over the first end of the fin, wherein the gate structure is on a top surface of the fin and a top surface of the first dielectric.

Example 2: the semiconductor device of Example 1, wherein the fin comprises: a plurality of semiconductor channels in a vertical stack.

Example 3: the semiconductor device of Example 1 or Example 2, wherein the top surface of the fin is substantially coplanar with the top surface of the first dielectric.

Example 4: the semiconductor device of Examples 1-3, further comprising: a second fin with a third end and a fourth end, wherein the third end of the second fin faces the second end of the fin, and wherein the second dielectric covers the third end of the second fin.

Example 5: the semiconductor device of Example 4, further comprising: a second gate structure over the second fin, wherein the second gate structure is on the second fin and the second dielectric.

Example 6: the semiconductor device of Examples 1-5, wherein the first dielectric and the second dielectric are connected by a third dielectric that is provided along a length of the fin.

Example 7: the semiconductor device of Example 6, wherein the third dielectric is spaced away from an edge of the fin that connects the first end of the fin to the second end of the fin.

Example 8: the semiconductor device of Example 7, wherein the gate structure is between the fin and the third dielectric.

Example 9: the semiconductor device of Examples 1-8, wherein the first dielectric has a substantially planar surface that contacts the first end of the fin.

Example 10: the semiconductor device of Examples 1-9, wherein the gate structure is a metal gate structure.

Example 11: the semiconductor device of Examples 1-10, wherein a face of the gate structure is offset from the first end of the fin.

Example 12: the semiconductor device of Examples 1-11, wherein the gate structure wraps around sidewalls of the fin and the top surface of the fin.

Example 13: the semiconductor device of Example 12, wherein the gate structure forms a U-shape around the fin.

Example 14: a method of forming a semiconductor device, comprising: providing a fin on a substrate, wherein the fin includes a pair of sidewalls and a top surface, wherein the fin comprises a plurality of semiconductor channels; forming a spacer over the sidewalls and the top surface of the fin; etching through the spacer and the fin to form a gap that splits the fin into a first fin and a second fin; depositing a dielectric layer in the gap, wherein the dielectric layer directly contacts the plurality of semiconductor channels; removing the spacer; and forming a first gate structure over an end of the first fin and a second gate structure over an end of the second fin.

Example 15: the method of Example 14, wherein the first gate structure lands on the first fin and the dielectric layer.

Example 16: the method of Example 14 or Example 15, wherein the second gate structure lands on the second fin and the dielectric layer.

Example 17: the method of Examples 14-16, wherein the first gate structure and the second gate structure are formed with a replacement metal gate process.

Example 18: the method of Examples 14-17, wherein the plurality of semiconductor channels are nanoribbon or nanowire channels.

Example 19: the method of Example 18 wherein the plurality of semiconductor channels are alternated with sacrificial layers, and wherein the sacrificial layers are ultimately removed and replaced with a gate dielectric and a gate metal.

Example 20: the method of Example 19, wherein the gate metal comprises a workfunction metal and a fill metal.

Example 21: the method of Examples 14-20, wherein after etching through the spacer and the fin to form the gap that splits the fin, an end surface of the first fin is substantially coplanar with a first surface of the spacer, and wherein an end surface of the second fin is substantially coplanar with a second surface of the spacer.

Example 22: the method of Examples 14-21, wherein the dielectric layer surrounds a perimeter of the first fin and the second fin.

Example 23: the method of Example 22, wherein a length edge of the first fin is spaced away from dielectric layer.

Example 24: an electronic system, comprising: a board; a package substrate coupled to the board; and a die coupled to the package substrate, wherein the die comprises a semiconductor device, comprising: a fin with a first end and a second end; a first dielectric that covers the first end of the fin; a second dielectric that covers the second end of the fin; a gate structure over the first end of the fin, wherein the gate structure is on a top surface of the fin and a top surface of the first dielectric.

Example 25: the electronic system of Example 24, wherein the first dielectric and the second dielectric are connected by a third dielectric that extends around a length of the fin, and wherein the third dielectric is spaced away from an edge of the fin that connects the first end of the fin to the second end of the fin.

## Claims

1. A semiconductor device, comprising:
a fin with a first end and a second end;
a first dielectric that covers the first end of the fin;
a second dielectric that covers the second end of the fin;
a gate structure over the first end of the fin, wherein the gate structure is on a top surface of the fin and a top surface of the first dielectric.

2. The semiconductor device of claim 1, wherein the fin comprises:
a plurality of semiconductor channels in a vertical stack.

3. The semiconductor device of claim 1 or 2, wherein the top surface of the fin is substantially coplanar with the top surface of the first dielectric.

4. The semiconductor device of claim 1, 2 or 3, further comprising:
a second fin with a third end and a fourth end, wherein the third end of the second fin faces the second end of the fin, and wherein the second dielectric covers the third end of the second fin.

5. The semiconductor device of claim 4, further comprising:
a second gate structure over the second fin, wherein the second gate structure is on the second fin and the second dielectric.

6. The semiconductor device of claim 1, 2, 3, 4 or 5, wherein the first dielectric and the second dielectric are connected by a third dielectric that is provided along a length of the fin.

7. The semiconductor device of claim 6, wherein the third dielectric is spaced away from an edge of the fin that connects the first end of the fin to the second end of the fin.

8. The semiconductor device of claim 7, wherein the gate structure is between the fin and the third dielectric.

9. The semiconductor device of claim 1, 2, 3, 4, 5, 6, 7 or 8, wherein the first dielectric has a substantially planar surface that contacts the first end of the fin.

10. The semiconductor device of claim 1, 2, 3, 4, 5, 6, 7, 8 or 9, wherein the gate structure is a metal gate structure.

11. The semiconductor device of claim 1, 2, 3, 4, 5, 6, 7, 8, 9 or 10, wherein a face of the gate structure is offset from the first end of the fin.

12. The semiconductor device of claim 1, 2, 3, 4, 5, 6, 7, 8, 9, 10 or 11, wherein the gate structure wraps around sidewalls of the fin and the top surface of the fin.

13. The semiconductor device of claim 12, wherein the gate structure forms a U-shape around the fin.

14. A method of forming a semiconductor device, comprising:
providing a fin on a substrate, wherein the fin includes a pair of sidewalls and a top surface, wherein the fin comprises a plurality of semiconductor channels;
forming a spacer over the sidewalls and the top surface of the fin;
etching through the spacer and the fin to form a gap that splits the fin into a first fin and a second fin;
depositing a dielectric layer in the gap, wherein the dielectric layer directly contacts the plurality of semiconductor channels;
removing the spacer; and
forming a first gate structure over an end of the first fin and a second gate structure over an end of the second fin.

15. The method of claim 14, wherein the first gate structure lands on the first fin and the dielectric layer.
